# EUROPEAN PATENT SPECIFICATION

(11) **EP 0 808 917 B1**
(45) Date of publication and mention of the grant of the patent: **10.04.2002**
(21) Application number: 96108108.0
(22) Date of filing: 21.05.1996
(51) Int. Cl.: C23C 16/44, C23C 16/46, C30B 25/10, H01L 21/00

(54) **Apparatus and method for controlling the temperature of a wall of a reaction chamber**
Verfahren und Vorrichtung zum Regeln der Temperatur einer Reaktorwand
Procédé et dispositif de régulation de la température d'une paroi d'un chambre de réaction

(43) Date of publication of application: 26.11.1997
(60) Divisional application: 01109786.2
(73) Proprietor: Applied Materials, Inc., Santa Clara, CA 95054 (US)
(72) Inventor: Carlson, David K., Santa Clara, CA 95051 (US); Riley, Norma, Pleasanton, CA 94588 (US); Anderson, Roger N., San Jose, CA 95124 (US)
(74) Representative: Zimmermann, Gerd Heinrich

(56) References cited:
- EP-A- 0 293 021
- EP-A- 0 467 392
- EP-A- 0 709 488
- US-A- 5 097 890
- US-A- 5 346 555

## Description

The invention relates to a temperature control apparatus and a concomitant method for controlling the temperature of the walls of a CVD reaction chamber.

In a conventional chemical vapor deposition (CVD) system, a reaction chamber envelopes a volume wherein the deposition process occurs. The chamber typically is fabricated of transparent quartz. As such, the reaction chamber is said to have quartz windows (accessible surfaces of the chamber) through which the temperature of the apparatus within the chamber can be optically monitored using optical pyrometers. In general, since the windows are integral with the walls of the chamber, the temperature of these windows is indicative of the chamber wall temperature. The temperature of the windows and the walls of the chamber vary depending upon the temperature of the workpiece within the chamber, the process presently being accomplished, the gases involved in the current process, and the run time of the process.

US 5,097,890 discloses a cooling system which is incorporated in a heat treating apparatus for use in a manufacturing process of a semiconductor device. The heat treating apparatus includes a reaction tube and a heater which surrounds the reaction tube. It further includes inlet means for blowing a cooling fluid and exhaust means for collecting that cooling fluid.

EP 0 709 488 discloses an apparatus for a thin film growth on a semiconductor crystal substrate. The quantities of impurities are reduced by forcibly cooling the wall of the reaction vessel by a coolant while the substrate is heated.

EP 0 293 021 describes a reactor for chemical vapor deposition of epitaxial layers on crystal substrates, using a medium frequency induction heating system. The power for said heating is provided by a multiturn coil. Properly shaped wall of the susceptor control the temperature gradient in the reactor.

More specifically, it is desirable that during a deposition process, the quartz wall temperature be controlled within a narrow temperature range to minimize deposits on the chamber wall. Furthermore, it is desirable that, during cleaning steps, the quartz wall temperature be maintained at a different temperature to maximize the etch rate of any film that may have been deposited on the chamber walls. Such temperature maintenance minimizes particulate contamination problems.

Typically, the temperature of the walls of the chamber is maintained at a nominal value by a flow of air proximate the outer surface of the chamber. This air flow is fixed for each process performed within the chamber. Thus, the temperature of the chamber walls varies with conditions within the chamber, e.g., the wall temperature differs depending on whether the process in the chamber is depositing material or etching material from a workpiece.

Through empirical study, it has been shown that the processes performed within the chamber can be optimized when the chamber wall temperature is maintained at an optimum temperature for a particular process. However, prior art CVD systems contemplate maintaining the air flow past the chamber at a fixed flow rate. As such, these systems exhibit significant chamber wall temperature variations which preclude a high degree of temperature optimization.

Therefore, a need exists in the art for closed loop apparatus, and a concomitant method, for controlling the air flow proximate a reaction chamber such that the temperature of the chamber walls can be readily optimized for each of the processes accomplished within the chamber.

It is the object of the present invention to overcome the above described drawbacks and the disadvantages heretofore associated with prior art CVD systems, and to provide an apparatus and a method which meet the above needs.

This object is solved by the apparatus for controlling the temperature of a wall of a reaction chamber according to independent claim 1, and the method for controlling the temperature of a wall of a reaction chamber according to independent claim 9.

Further advantageous features, aspects and details of the invention are evident from the dependent claims, the description and the drawings.

Specifically, the present invention provides an apparatus and a concomitant method for controlling coolant flow, preferably air flow, proximate a reaction chamber within a CVD system such that the temperature of the walls of the reaction chamber is maintained at a predefined target temperature. The target temperature is typically a temperature that optimizes a process currently being accomplished within the chamber.

According to a first aspect, the present invention provides an apparatus for controlling the temperature of a wall of a reaction chamber comprising:
an inlet conduit, connected to a shroud, for carrying a coolant to said shroud, said shroud confines and controls the coolant flow proximate said reaction chamber;
an outlet conduit, connected to said shroud, for exhausting said coolant from said shroud;
an air vane located within said inlet conduit for controlling an amount of coolant that flows into said shroud, the air vane being selectively positionable to restrict the flow of coolant through said inlet conduit into said shroud,
means for measuring a temperature of said wall of said reaction chamber; and
means for controlling said coolant flow control device in response to the measured temperature such that said measured temperature is altered by altering the coolant flow proximate the reaction chamber until the measured temperature attains a target temperature.

According to a second aspect, the present invention provides a method of controlling the temperature of a wall of a reaction chamber comprising the steps of:
supplying, through an inlet conduit, coolant to a shroud that channels the coolant past said reaction chamber;
exhausting, through an outlet conduit, coolant from said housing after said coolant has flowed past said wall of said reaction chamber;
measuring a temperature of said wall of said reaction chamber;
selecting a target temperature; and
adjusting an air vane located within said inlet conduit, the air vane being selectively positionable to restrict the flow of coolant through said inlet conduit into said shroud, such that the flow of coolant past said wall of said reaction chamber is regulated and said measured temperature becomes substantially equivalent to said target temperature.

More specifically, the present invention uses an optical pyrometer (or thermocouple) to measure the temperature of a wall of the reaction chamber. The measured temperature is compared to the target temperature. Preferably, a closed loop apparatus controls the air flow past the outer surface of the reaction chamber such that the measured temperature becomes substantially equal to the target temperature. Advantageously, air flow control is provided by a positionable air vane located within an inlet conduit that supplies air to a shroud for channeling air past the reaction chamber. As such, positioning of the air vane regulates the air flow proximate the reaction chamber and, consequently, regulates the temperature of the reaction chamber walls.

In operation, a user can predefine a number of target temperatures that are optimal for particular processes to be performed within the chamber. The apparatus and method according to the present invention adjusts the air flow to achieve and maintain each target temperature during an associated process. Consequently, an optimal reaction chamber wall temperature is used during each process.

The teachings of the present invention can be readily understood by considering the following detailed description in conjunction with the accompanying drawings, in which:
FIG. 1 shows a simplified cross-sectional view of a thermal reaction chamber containing an optical pyrometer for monitoring the temperature of a wall of the chamber;
FIG. 2 shows a simplified cross-sectional view of a thermal reaction chamber containing a thermocouple for monitoring the temperature of a wall of the chamber;
FIG. 3 depicts a block diagram of circuitry used to provide a closed loop temperature control system; and
FIG. 4 depicts a flow chart of a closed loop control routine.

To facilitate understanding, identical reference numerals have been used, where possible, to designate identical elements that are common to the figures.

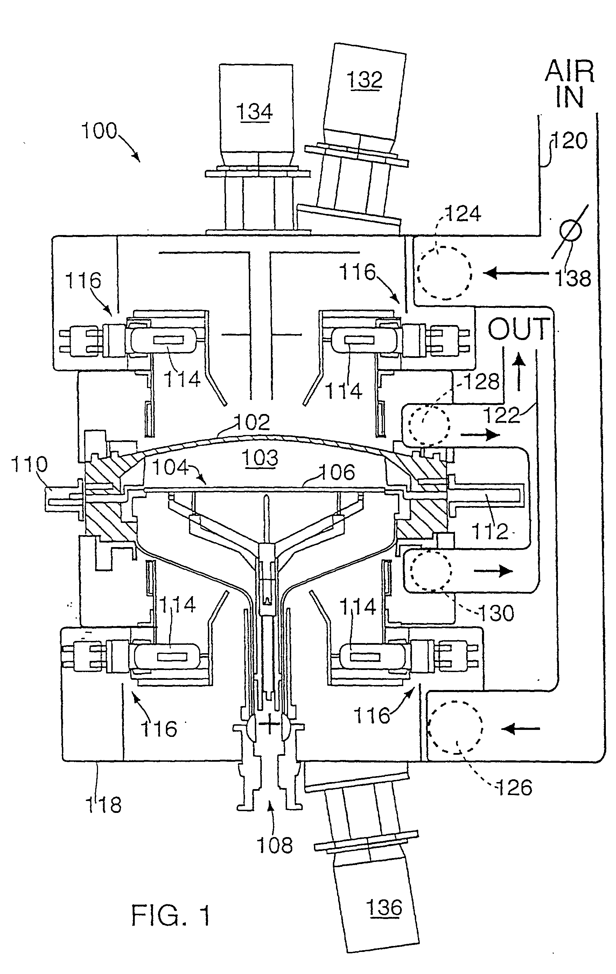

FIG. 1 shows a cross-sectional view of a thermal reaction chamber 102 used in a chemical vapor deposition (CVD) system 100. The chamber has walls that define an inner volume 103 wherein the reactive CVD processes are accomplished. A housing 118 envelopes and supports the chamber 102. Within the inner volume 103 of chamber 102, a workpiece support structure 104 is used. to support a workpiece 106 during CVD processing. Such workpiece support structures are generally referred to in the art as susceptors. The workpiece support structure 104 extends through a bottom aperture 108 of the chamber 102. Such an extension enables a drive assembly (not shown) to rotate the workpiece support structure 104, and thus the workpiece 106, during processing. Such rotation is accomplished to enhance process uniformity.

During processing, gases enter the chamber through an entry port 110 and are removed through an exhaust port 112. Also during processing, heat is provided by infrared radiation bulbs 114. The infrared radiation bulbs are mounted, proximate the chamber, on a support assembly 116 connected to a housing 118. The walls of the chamber are transparent, allowing infrared radiation from the radiation bulbs to freely enter the reaction chamber and heat the workpiece.

A more complete description of thermal reactors and their operation is disclosed in commonly assigned U.S. patent 5,258,824 entitled "In-Situ Measurement Of A Thin Film Deposited On A Wafer" and U.S. patent 5,108,792 entitled "Double Dome Reactor for Semiconductor Processing", each of which is incorporated herein by reference.

During processing, the quartz windows (e.g., accessible portions of the transparent chamber walls), although transparent, still become heated. A coolant flow for cooling the chamber walls is supplied to the housing 118 from a blower (not shown) via inlet conduit 120, directed past the chamber and exhausted through outlet conduit 122. More specifically, the coolant flow is supplied via conduit 120 to housing 118 through upper and lower inlet ports 124 and 126. The coolant flow exits the housing 118 through upper and lower exhaust ports 128 and 130. The housing 118 forms a shroud that channels the coolant past the chamber walls. This constant flow of coolant proximate an outer surface of the chamber cools the walls of the chamber 102. Typically, the coolant is air. An air vane 138 or other coolant flow control device, located in the inlet conduit 120, controls the amount of air flow to the housing and, in turn, controls the temperature of the walls of the chamber. Alternatively, other devices for controlling the coolant flow may be used, such as an adjustable iris, a valve, blower speed control circuitry and the like.

The temperature of the quartz chamber walls is monitored using a conventional optical pyrometer 132. This optical pyrometer should be capable of measuring temperatures in the range of 100 degrees centigrade to 800 degrees centigrade and of detecting a wavelength of between 4.8 and 5.2 µm. Such an optical pyrometer is available from Ircon, Inc. having a business address of 7300 North Natchez Avenue, Niles, Illinois 60648, or from Linear Labs, having a business address of 1290 Hammerwood Avenue, Sunnyvale, California 94089. Similar optical pyrometers are used to measure the temperature of the workpiece 106 (pyrometer 134) and to measure the temperature of the workpiece support structure 104 (pyrometer 136). These pyrometers should be able to measure a temperature range of 500 degrees centigrade to 1250 degrees centigrade and detect a wavelength of between two and four µm.

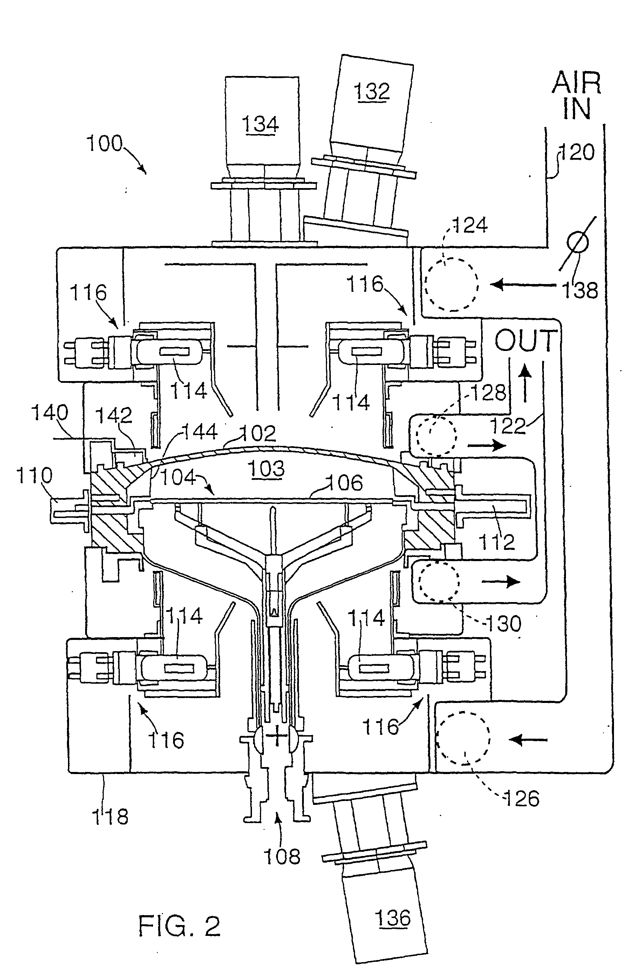

Alternatively, other means of measuring the temperature of the reaction chamber walls could be used. One example of an alternative temperature measuring device, shown in FIG. 2, is a shielded thermocouple 140. The thermocouple 140 is attached directly to the outer surface of the reaction chamber 102. Specifically, the thermocouple 140 is mounted under a shield 142 and located directly above an upper quartz liner 144. As such, the temperature of the chamber wall is directly monitored and the thermocouple produces a signal indicative of the measured temperature.

An output signal from the optical pyrometer 132 (or thermocouple 140) is received and processed by signal processing circuitry (not shown). This circuitry may be as simple as a temperature display that converts the electrical output signal from the temperature measuring device into a display of the temperature value represented by the signal, e.g., a light emitting diode or liquid crystal numerical display. An operator, in response to the displayed temperature, manually adjusts the air flow control device such that the air flow across the reaction chamber is altered. In this manner, the operator can adjust the temperature of the chamber walls measured by the pyrometer (or thermocouple) until the measured temperature is equivalent to a target temperature as indicated on the display. Typically, the target temperature is a temperature that optimizes the present CVD process being accomplished within the chamber.

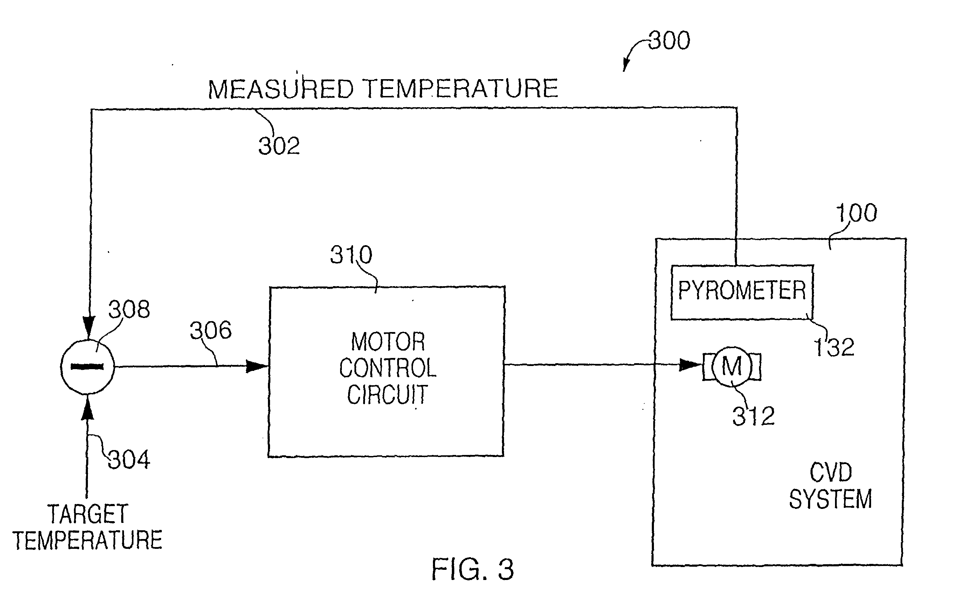

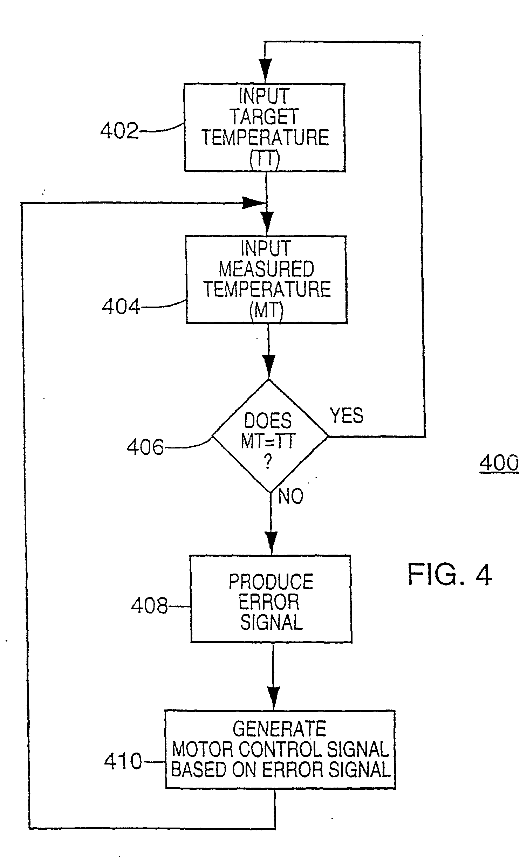

In the foregoing simple implementation of the invention, an operator forms a portion of the closed loop system controlling the measured temperature until attaining a target temperature. Using electrical circuitry, a closed loop circuit can be used to automate this closed loop. In that regard, FIG. 3 depicts a simplified block diagram of a closed loop system that controls the temperature of the chamber walls. FIG. 4 depicts a flow chart of a routine illustrating the process by which this closed loop system functions. To best understand the operation of this closed loop system, the reader should simultaneously refer to both FIGS. 3 and 4.

In this embodiment of the invention, the closed loop system 300 monitors a temperature signal (line 302) generated by the pyrometer 132 (or thermocouple), compares, using a subtractor 308, the measured temperature signal to a target temperature value (line 304), and generates an error signal (line 306) representing the difference between the target temperature and the measured temperature. The target temperature could be manually entered into the system or defined by a computer algorithm that is controlling the processing within the chamber. In any event, the error signal forms an input to a motor control circuit 310. The motor control circuit, in response to the error signal, controls a stepper motor 312 that adjusts the air vane. This air vane adjustment moves the air vane such that the error signal is minimized. This entire operation is performed at timed intervals to minimize the error signal and counteract any variation in wall temperature. Consequently, the quartz wall temperature is adjusted to equal the target temperature.

The process involved in this closed loop control of the chamber wall temperature is summarized in the flow chart of FIG. 4. At step 402, the target temperature (TT) is input to the system. At step 404, the measured temperature (MT) is generated by the pyrometer (or thermocouple). At step 406, the routine queries whether the target temperature is equal to the measured temperature. If the temperatures are equal, the routine loops, along YES path 412, to the beginning of the routine and repetitively measures and compares the target and measured temperatures until the query is negatively answered.

If the target and measured temperatures are not equal, the routine proceeds along the NO path emanating from step 406 to step 408. At step 408, the routine produces an error signal by subtracting the measured temperature from the target temperature. At step 410, the motor control circuit generates, in response to the error signal, an appropriate motor control signal. This motor control signal activates the stepper motor and adjusts the position of the air vane. By repeating this routine, the system adjusts the air flow until the target and measured temperatures are equal. Subsequently, the routine continuously monitors the measured temperature and continuously adjusts the air vane position to maintain the measured temperature at the target temperature.

Using this method and system, the temperature of the chamber walls can be set to a target temperature that optimizes the CVD process presently occurring in the chamber. The same system and method maintains that target temperature throughout the process. Subsequently, for other processes, other target temperatures can be selected, established and maintained by the invention.

Additionally, the disclosed routine can be implemented as a software program executed upon a microprocessor (computer) that controls the CVD processing. As such, the microprocessor produces the signals that control the air flow control device.

## Claims

1. Apparatus for controlling the temperature of a wall of a reaction chamber (102) comprising:
an inlet conduit (120), connected to a shroud, for carrying a coolant to said shroud, said shroud confines and controls the coolant flow proximate said reaction chamber(102);
an outlet conduit (122), connected to said shroud, for exhausting said coolant from said shroud;
an air vane (138), located within said inlet conduit (120), for controlling an amount of coolant that flows into said shroud, the air vane (138) being selectively positionable to restrict the flow of coolant through said inlet conduit (120) into said shroud,
means (132;140) for measuring a temperature of said wall of said reaction chamber (102); and
means (300) for controlling said air vane (138) in response to the measured temperature such that said measured temperature is altered by altering the coolant flow proximate the reaction chamber (102) until the measured temperature attains a target temperature.

2. The apparatus of claim 1 wherein said shroud forms a portion of a housing (118) for said reaction chamber.

3. The apparatus of claim 1 or 2, wherein said coolant is air.

4. The apparatus of any of claims 1 to 3, wherein said temperature measuring means (132) is an optical pyrometer.

5. The apparatus of any of claims 1 to 3, wherein said temperature measuring means (140) is a thermocouple.

6. The apparatus of any of claims 1 to 5 wherein said means (300) for controlling said air vane (138) is a closed loop system having said measured temperature and said target temperature as input signals and producing an error signal indicative of the difference between said target temperature and said measured temperature.

7. The apparatus of claim 6 wherein said means (300) for controlling said air vane adjusts said vane in response to said error signal such that said error signal is minimized.

8. The apparatus of claim 7 wherein said means (300) for controlling said air vane (138) further comprises a motor control circuit (310) electrically connected to a stepper motor (312) that selectively positions said air vane, said motor control circuit (310) produces, in response to said error signal, a motor drive signal for positioning said stepper motor (312) such that said air vane is positioned to minimize said error signal.

9. A method of controlling the temperature of a wall of a reaction chamber comprising the steps of:
supplying, through an inlet conduit, coolant to a shroud that channels the coolant past said reaction chamber;
exhausting, through an outlet conduit, coolant from said housing after said coolant has flowed past said wall of said reaction chamber;
measuring a temperature of said wall of said reaction chamber;
selecting a target temperature; and
adjusting an air vane located within said inlet conduit, the air vane being selectively positionable to restrict the flow of coolant through said inlet conduit into said shroud, such that the flow of coolant past said wall of said reaction chamber is regulated and said measured temperature becomes substantially equivalent to said target temperature.

10. The method of claim 9 wherein said coolant is air.

11. The method of claim 9 or 10 wherein the shroud is a portion of a housing for said reaction chamber.

12. The method of any one of claims 9 to 11 wherein said adjusting step further comprises the steps of:
computing an error signal indicative of the difference between said measured temperature and said target temperature; and
controlling, in response to said error signal, the air vane such that said error signal is minimized.

13. The method of claim 12 wherein said computing step further comprises the steps of:
supplying said error signal to a motor control circuit;
generating, within said motor control circuit, a motor control signal that is responsive to said error signal;
activating, in response to said motor control signal, a motor that is coupled to said air vane such that said air vane is positioned to regulate said air flow and minimize said error signal.

## Patentansprüche

1. Vorrichtung zur Steuerung der Wandtemperatur einer Reaktorkammer (102), umfassend:
eine mit einem Ablenkblech verbundene Einlaßleitung (120) zum Zuführen eines Kühlmittels zu dem Ablenkblech, wobei das Ablenkblech den Kühlmittelfluß in der Nähe der Reaktorkammer (102) einschließt und steuert;
eine mit dem Ablenkblech verbundene Auslaßleitung (122) zum Auslassen des Kühlmittels von dem Ablenkblech;
eine in der Einlaßleitung (120) angeordnete Luftklappe (138) zum Steuern einer Kühlmittelmenge, die zu dem Ablenkblech fließt, wobei die Luftklappe (138) selektiv einstellbar ist, um den Kühlmittelfluß durch die Einlaßleitung (120) zu dem Kühlmittelblech zu begrenzen,
eine Einrichtung (132; 140) zur Temperaturmessung der Wand der Reaktorkammer (102); und
eine Einrichtung (300) zur Steuerung der Luftklappe (138) in Antwort auf die gemessene Temperatur, so daß sich die gemessene Temperatur durch Ändern des Kühlmittelflusses nahe der Reaktorkammer verändert, bis die gemessene Temperatur eine Zieltemperatur erreicht.

2. Vorrichtung nach Anspruch 1, wobei das Ablenkblech einen Bereich eines Gehäuses (118) der Reaktorkammer bildet.

3. Vorrichtung nach Anspruch 1 oder 2, wobei das Kühlmittel Luft ist.

4. Vorrichtung nach einem der Ansprüche 1 bis 3, wobei die Einrichtung (132) zur Temperaturmessung ein optisches Pyrometer ist.

5. Vorrichtung nach einem der Ansprüche 1 bis 3, wobei die Einrichtung (140) zur Temperaturmessung ein Thermoelement ist.

6. Vorrichtung nach einem der Ansprüche 1 bis 5, wobei die Einrichtung (300) zur Steuerung der Luftklappe (138) ein geschlossenes Regelsystem ist, das die gemessene Temperatur und die Zieltemperatur als Eingangssignale erhält und das ein der Differenz zwischen der Zieltemperatur und der gemessenen Temperatur entsprechendes Fehlersignal erzeugt.

7. Vorrichtung nach Anspruch 6, wobei die Einrichtung (300) zur Steuerung der Luftklappe die Klappe in Antwort auf das Fehlersignal einstellt, so daß das Fehlersignal minimiert wird.

8. Vorrichtung nach Anspruch 7, wobei die Einrichtung (300) zur Steuerung der Luftklappe (138) weiterhin einen Motorregelkreis (310) umfaßt, der mit einem Schrittmotor (312), der die Luftklappe selektiv einstellt, elektrisch verschaltet ist, wobei der Motorregelkreis (310) in Antwort auf das Fehlersignal ein Motorantriebssignal zum Einstellen des Schrittmotors (312) erzeugt, so daß die Luftklappe eingestellt ist, um das Fehlersignal zu minimieren.

9. Verfahren zur Steuerung der Wandtemperatur einer Reaktorkammer, umfassend die Schritte:
Zuführen eines Kühlmittels durch eine Einlaßleitung zu einem Ablenkblech, welches das Kühlmittel an der Reaktorkammer vorbeiführt;
Auslassen des Kühlmittels aus dem Gehäuse durch eine Auslaßleitung, nachdem das Kühlmittel an der Wand der Reaktorkammer vorbeigeströmt ist;
Messen der Temperatur der Reaktorkammerwand;
Auswählen einer Zieltemperatur; und
Einstellen einer innerhalb der Einlaßleitung angeordneten Luftklappe, wobei die Luftklappe eingestellt wird, um den Kühlmittelfluß durch die Einlaßleitung in das Ablenkblech zu begrenzen, so daß der Kühlmittelfluß entlang der Reaktorkammerwand geregelt wird und die gemessene Temperatur im wesentlichen gleich der Zieltemperatur wird.

10. Verfahren nach Anspruch 9, wobei das Kühlmittel Luft ist.

11. Verfahren nach Anspruch 9 oder 10, wobei das Ablenkblech einen Bereich des Gehäuses der Reaktorkammer bildet.

12. Verfahren nach einem der Ansprüche 9 bis 11, wobei der Schritt des Einstellens weiterhin die Schritte umfaßt:
Berechnen eines Fehlersignals, das der Differenz zwischen der gemessenen Temperatur und der Zieltemperatur entspricht; und
Steuern der Luftklappe in Antwort auf das Fehlersignal, so daß das Fehlersignal minimiert wird.

13. Verfahren nach Anspruch 12, wobei der Berechnungsschritt weiterhin die Schritte umfaßt:
Zuführen des Fehlersignals zu einem Motorregelkreis;
Erzeugen eines Motorsteuerungssignals in dem Motorregelkreis, das auf das Fehlersignal reagiert;
Antreiben eines mit der Luftklappe verbundenen Motors in Antwort auf das Motorsteuerungssignal, so daß die Luftklappe eingestellt wird, um den Luftfluß zu regeln und das Fehlersignal zu minimieren.

## Revendications

1. Appareil de régulation de la température d'une paroi d'une chambre de réaction (102) comprenant :
un conduit d'entrée (120), connecté à un carénage, pour transporter un agent réfrigérant vers ledit carénage, ledit carénage confinant et régulant l'écoulement d'agent réfrigérant à proximité de ladite chambre de réaction (102) ;
un conduit de sortie (122), connecté audit carénage, pour évacuer ledit agent réfrigérant dudit carénage ;
une pale à air (138), disposée à l'intérieur dudit conduit d'entrée (120), pour réguler une quantité d'agent réfrigérant qui s'écoule au sein dudit carénage, la pale à air (138) pouvant être sélectivement positionnée de manière à diminuer l'écoulement d'agent réfrigérant au travers dudit conduit d'entrée (120) dans ledit carénage,
un moyen (132; 140) pour mesurer une température de ladite paroi de ladite chambre de réaction (102) ; et
un moyen (300) pour commander ladite pale à air (138) en fonction de la température mesurée de sorte que ladite température mesurée soit modifiée en modifiant l'écoulement de l'agent réfrigérant à proximité de la chambre de réaction (102) jusqu'à ce que la température mesurée atteigne une température cible.

2. Appareil selon la revendication 1, dans lequel ledit carénage forme une partie d'un logement (118) pour ladite chambre de réaction.

3. Appareil selon la revendication 1 ou 2, dans lequel ledit agent réfrigérant est de l'air.

4. Appareil selon l'une quelconque des revendication 1 à 3, dans lequel ledit moyen de mesure de la température (132) est un pyromètre optique.

5. Appareil selon l'une quelconque des revendications 1 à 3, dans lequel ledit moyen de mesure de la température (140) est un thermocouple.

6. Appareil selon l'une quelconque des revendications 1 à 5, dans lequel ledit moyen (300) pour commander ladite pale à air (138) est un système en boucle fermée ayant ladite température mesurée et ladite température cible comme signaux d'entrée et produisant un signal d'erreur révélateur de la différence entre ladite température cible et ladite température mesurée.

7. Appareil selon la revendication 6, dans lequel ledit moyen (300) pour commander ladite pale à air ajuste ladite pale en réponse audit signal d'erreur de sorte que ledit signal d'erreur soit réduit au minimum.

8. Appareil selon la revendication 7, dans lequel ledit moyen (300) pour commander ladite pale à air (138) comprend, en outre, un circuit de commande moteur (310) connecté électriquement à un moteur pas-à-pas (312) qui positionne sélectivement ladite pale à air, ledit circuit de commande moteur (310) produisant, en réponse audit signal d'erreur, un signal d'actionnement moteur pour positionner ledit moteur pas-à-pas (312) de sorte que ladite pale à air soit positionnée de manière à réduire au minimum ledit signal d'erreur.

9. Procédé de régulation de la température d'une paroi d'une chambre de réaction comprenant les étapes qui consistent à :
fournir, au travers d'un conduit d'entrée, un agent réfrigérant à un carénage qui canalise l'agent réfrigérant le long de ladite chambre de réaction,
évacuer, au travers d'un conduit de sortie, l'agent réfrigérant à partir dudit logement après que ledit agent réfrigérant se soit écoulé le long de ladite paroi de ladite chambre de réaction,
mesurer une température de ladite paroi de ladite chambre de réaction,
sélectionner une température cible, et
ajuster une pale à air disposée à l'intérieur dudit conduit d'entrée, la pale à air pouvant être sélectivement positionnée pour diminuer l'écoulement d'agent réfrigérant au travers dudit conduit d'entrée dans ledit carénage, de sorte que l'écoulement d'agent réfrigérant le long de ladite paroi de ladite chambre de réaction soit régulé et que ladite température mesurée devienne sensiblement équivalente à ladite température cible.

10. Procédé selon la revendication 9, dans lequel ledit agent réfrigérant est de l'air.

11. Procédé selon la revendication 9 ou 10, dans lequel le carénage est une partie d'un logement de ladite chambre de réaction.

12. Procédé selon l'une quelconque des revendications 9 à 11, dans lequel ladite étape d'ajustement comprend, en outre, les étapes qui consistent à :
calculer un signal d'erreur révélateur de la différence entre ladite température mesurée et ladite température cible, et
commander, en réponse audit signal d'erreur, la pale à air de sorte que ledit signal d'erreur soit réduit au minimum.

13. Procédé selon la revendication 12, dans lequel ladite étape de calcul comprend, en outre, les étapes qui consistent à :
fournir ledit signal d'erreur à un circuit de commande moteur,
générer, au sein dudit circuit de commande moteur, un signal de commande moteur qui répond audit signal d'erreur, et
activer, en réponse audit signal de commande moteur, un moteur qui est couplé à ladite pale à air de sorte que ladite pale à air soit positionnée de manière à réguler ledit écoulement d'air et réduise au minimum ledit signal d'erreur.
